(19) Europäisches Patentamt
European Patent Office
Office européen des brevets

(11) EP 0 350 888 B1

# (12) EUROPEAN PATENT SPECIFICATION

(45) Date of publication and mention
of the grant of the patent:
**18.09.1996 Bulletin 1996/38**

(51) Int Cl.⁶: **G06F 11/26**, G01R 31/28, G11C 29/00

(21) Application number: **89112727.6**

(22) Date of filing: **12.07.1989**

(54) **Signature compression circuit**

Schaltung zur Signaturkompression

Circuit de compression de signature

(84) Designated Contracting States:
**DE FR GB**

(30) Priority: **12.07.1988 JP 171906/88**

(43) Date of publication of application:
**17.01.1990 Bulletin 1990/03**

(73) Proprietor: **KABUSHIKI KAISHA TOSHIBA**
**Kawasaki-shi, Kanagawa-ken 210 (JP)**

(72) Inventor: **Nozuyama, Yasuyuki**
**Megro-ku Tokyo (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
EP-A- 0 093 947        EP-A- 0 148 403
WO-A-88/03291          US-A- 4 377 757

- **PROCEEDINGS OF THE NATIONAL COMMUNICATIONS FORUM, PART II, vol. 40, 1986, Oak Brook, Illinois, US, pp. 1176-1179; C.E. STROUD et al.: 'BIST for Embedded RAMs, ROMs, and PLAs in Custom VLSI'**
- **BUILT-IN LOGIC BLOCK OBSERVATION TECHNIQUES, 1979 IEEE Test Conference Cherry Hill, New Jersey, pages 37-41, by Bernd Könneman, Joachim Mucha and Günther Zwiehoff**
- **GRONDSLAGEN VAN DE ELEKTRONICA IV, PRISMA TECHNICA, 1970, pp. 75, 76 by Prof. Dr. Ir. J. DAVIDSE**

## Description

BACKGROUND OF THE INVENTION

Field of the Invention

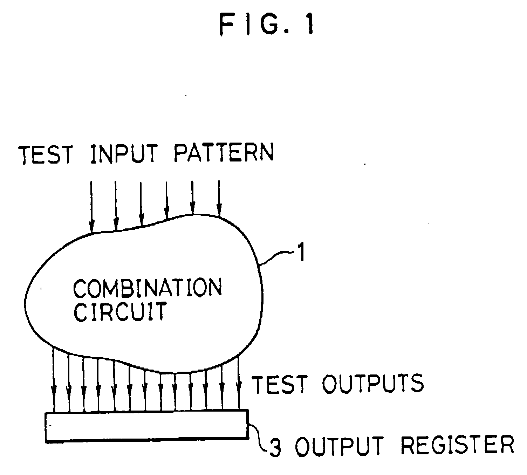

The invention relates to a signature compression circuit according to the preamble of claim 1. Such a signature compression circuit is known from Proc. 1979 IEEE Int. Test Conf. pages 35-41, "Built-in logic block observation techniques", by B. Köhnemann et al, 1979. Coherent with the preamble of claim 1, this reference describes the basic idea of a parallel signature analysis, which is suitable for built-in self-test of hardware blocks having a regular structure. The method consists of three modes, i.e. a normal mode, a scan mode, in which the signature of all results is scanned out to somewhere for comparison with the expected value and a test mode, in which the BILBO-output register behaves as a parallel input linear-feedback shift-register, in which test results are compressed. As will be further explained with reference to fig. 1, in such a BILBO-circuit, there is provided a NAND-gate between the registers and each individual input line. The NAND-circuit receives one of the control signals for bringing the BILBO-circuit into one of its three modes. US-A-4,377,757 discloses a similar circuit for promoting testing of an integrated circuit. Here, test data is also supplied to registers via a logic gate.

EP-A-0 093 947 discloses a programmable logic arrangement, consisting of a product matrix PM and a summation matrix SM consisting of a number of product lines and summation lines, respectively. Each input variable is input to the product matrix via inverters. To the product lines of the product matrix, there are connected respective transistors, which ground the product lines in response to a control signal, this causing a cancellation of the data value on the product lines.

Description of the Prior Art

One method employed to analyze high integrated circuits is a parallel signature compression method. This method will be explained with reference to Fig. 1. In the figure, a combination circuit 1 is tested. A test input pattern is given to the combination circuit 1, which provides a test output to an output register 3. The test outputs are compressed in the output register 3 in parallel. At the end of the test, a signature (a resultant data) of the test is stored in the register 3. Analysis of the combination circuit 1 according to the parallel signature compression method will be explained in more detail.

The test outputs of the combination circuit 1 are fetched by the output register 3. The output register 3 operates as a linear feedback shift register (LFSR) of parallel inputs, and the test outputs of the combination circuit 1 are compressed in parallel in the output register 3.

Simultaneously, with the grounding of the product lines, the control signal is applied to a number of switching circuits, which are in turn connected to the sum lines of the sum matrix. The switching elements receive data signals. Therefore, when the control signal grounds the product lines, an additional data value received by the switching elements is switched to the sum lines by said switching elements.

The compression circuit of the invention latches test outputs form an object to be tested, compresses them in parallel and gives a signature (a resultant data) of the test at the end of the test and reads the signature by scanning. In particular, the invention is effective for simplifying the design of test circuits.

A signature (a resultant data) of the test which is generated by compressing the test outputs of the combination circuit 1 is read out of the output register 3 by scanning and transferring. Then, the externally read contents are compared with expected values. Based on the comparison, the combination circuit 1 is analyzed.

In this way, the output register 3 shall latch the test outputs, compress them in parallel and carry out the scanning operation. To do so, the output register 3 is provided with hardware for realizing such operations.

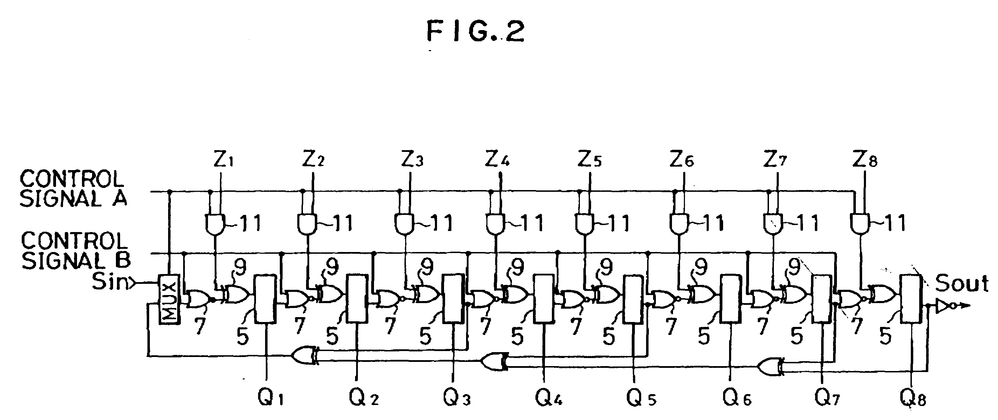

Figure 2 shows a conventional signature compression circuit comprising an output register provided with such hardware for executing the parallel signature compression. The circuit of Fig. 2 is based on a built-in logic block observer (BILBO) system.

In the figure, test outputs of a combination circuit to be tested are eight bits (Z1 to Z8)., and the output register comprises flip-flop circuits (hereinafter referred to as F/Fs) 5 corresponding to the eight bits of test outputs, respectively. Each F/F 5 is connected to the next F/F 5 on the upper bit side via a negative OR (NOR) gate 7 and an exclusive OR (EXOR) gate 9. Each F/F 5 receives corresponding one of the test outputs via an AND gate 11 and the EXOR gate 9. One input of each AND gate 11 receives a control signal A, and one input of each NOR gate 7 receives a control signal B. These control signals A and B control outputs of the gates 7 and 11.

When the control signal A is at a level of "1", the gates 11 are enabled so that the test outputs Zn are latched in the output register that may form a linear feedback shift register (LFSR). When the control signal B is at a level of "1", the gates 7 are disabled so that the F/Fs 5 will be independent of each other. In this way, the control signals A and B determine a function of the output register as a whole.

To compress the test outputs in parallel, the conventional signature compression circuit based on the BILBO system shall have gate circuits such as the EXOR gates 9 and AND gates 11 to be inserted between the outputs of a circuit to be tested and the output register comprising the F/Fs 5.

Therefore, if the number of outputs of the circuit to be tested is large, the number of the gate circuits shall be increased, i.e., areas occupied by the gate circuits in an integrated circuit shall be increased, thus increasing the size of the integrated circuit.

Since the test outputs are given to the F/Fs via the two stages of gate circuits, there are delays caused by the two stages of gage circuits. If high speed specifications shall be observed, it is hard to employ such conventional signature compression circuits, or, if employed, the specifications shall be loosened.

## SUMMARY OF THE INVENTION

An object of the present invention is to provide a signature compression circuit that operates at high speed to receive test data within a short time and comprises a small number of elements. This object is solved by claim 1. Further advantageous embodiments and improvements of the invention may be taken from the attached dependent claims.

One aspect of the present invention provides a signature compression circuit comprising a linear feedback shift register (LFSR) and transistors that are arranged between output terminals of a logic circuit to be tested and a ground level. The transistors select for the output register a test data input mode or a compression mode and a scan mode. The logic circuit to be tested provides proportional type outputs or dynamic type outputs.

When the transistors are OFF, test data from the logic circuit to be tested are inputted to the output register which forms a LFSR and compresses the test data in test mode. When the transistors are ON, all the output terminals of the logic circuit to be tested are grounded, and the data in the output register can be shifted. Instead of the ground level, a logic level may be used to embody the invention.

In addition to the logic circuits providing the ratio-type or dynamic type outputs, any other types of logic circuits may be tested by the invention, if the logic circuits cause no troubles when their output terminals are set to a predetermined logic level by means of transistors.

According to an aspect of the invention, the transistors are switched over with a common control signal to set outputs of the logic circuit to be tested to a predetermined logic level so that a signature (a resultant data) of the test already formed in the LFSR may be scanned.

These and other objects, features and advantages of the present invention will be more apparent from the following detailed description of preferred embodiments in conjunction with the accompanying drawings.

## BRIEF DESCRIPTION OF THE DRAWINGS

Fig. 1 is a view schematically explaining a test of a logic circuit;

Fig. 2 is a circuit diagram showing a conventional signature compression circuit;

Fig. 3(A) is a circuit diagram showing a signature compression circuit according to the present invention;

Figs. 3(B) to 3(D) are views explaining operations of the signature compression circuit of the invention;

Fig. 4 is a circuit diagram showing part of an embodiment of the invention applied for testing a logic circuit that provides ratio-type outputs; and

Fig. 5 is a circuit diagram showing part of an embodiment of the invention applied for testing a logic circuit that provides dynamic type outputs.

## DETAILED DESCRIPTION OF THE EMBODIMENTS

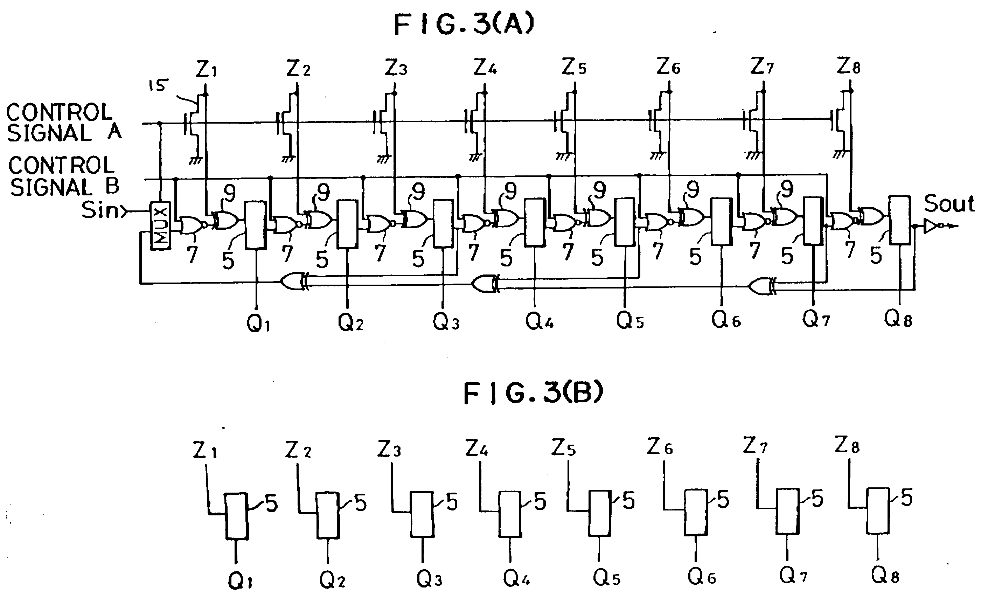

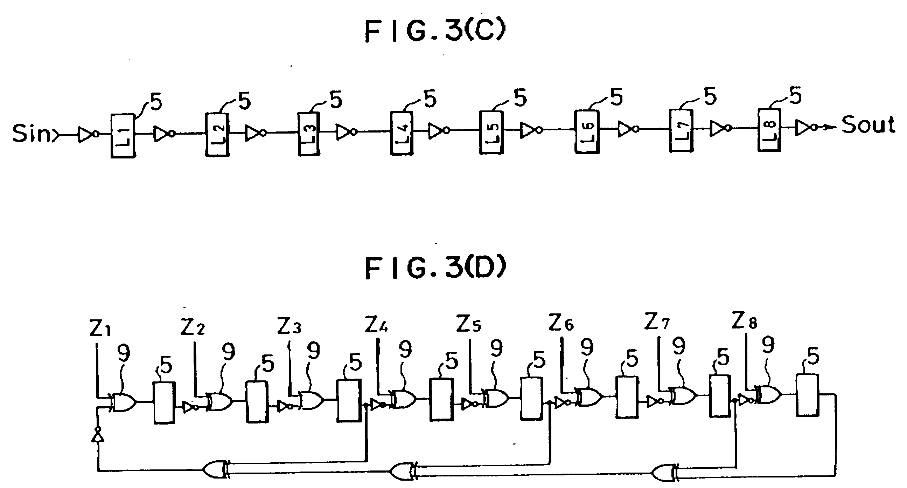

Figure 3(A) shows a parallel signature compression circuit according to an embodiment of the invention. In the figure, parts corresponding to those shown in Fig. 2 are represented with like reference marks. Although an 8-bit register is used as an output register in the embodiment, the larger the bit number the output register has, the higher the ability for finding out faults in a logic circuit to be tested becomes. It is practical to employ 32-bit registers.

In Fig. 3(A), input terminals Zn (n = 1 to 8) of the output register are connected to output terminals of a logic circuit to be tested. The logic circuit is preferable to be of ratio-type or dynamic type. each of the input terminals Zn is connected to a ground level via an NMOS transistor 15. A control signal A is given to a gate terminal of each transistor 15. The output register comprises flip-flop circuits (hereinafter referred to as F/Fs) 5 corresponding to test outputs provided by the logic circuit to be tested, respectively. Each F/F 5 is connected to the next F/F 5 on the upper bit side via a negative OR (NOR) gate 7 and an exclusive OR (EXOR) gate 9. To each F/F 5, corresponding one of the test outputs is given through the EXOR gate 9. A control signal B is given to one input of each NOR gate 7. The control signals A and B control outputs of the gates 7 and 9. Namely, the control signals A and B determine functions of the output registers.

When the control signal A is at a level of "0" and the control signal B at a level of "1," an output of each NOR gate 7 will be 0. Since the transistors 15 are OFF with the control signal A of 0, the input terminals Zn receive test outputs. Then, the EXOR gates 9 output the test outputs, which are set in the corresponding F/Fs 5. The circuit to be tested operates in normal mode. Namely, the signature compression circuit shown in Fig. 3(A) functions as shown in Fig. 3(B).

When the control signal A is "1" while the control signal B is "0," the transistors 15 are ON so that the input terminals Zn will each be 0. Then, an output of each NOR gate 7 will be an inverted output of the adjacent F/F on the lower bit side. In other words, an output of one F/F 5 is inverted and given to the next F/F 5 on the upper bit side. Namely, test outputs latched in the F/Fs 5 are scanned and shifted toward upper bits, and read outside. Here, the circuit of Fig. 3(A) forms a shift register as shown in Fig. 3(C) to transfer the signature of the test.

When the control signals A and B are both "0," each test output (signature) is given to one input of corresponding one of the EXOR gates 9, and an inverted output of the adjacent F/F 5 on the lower bit side is given to the other input of the EXOR gate 9 in question. As a result, one test output given to the input terminal Zi (i= 1 to 8) is exclusively ORed with an inverted output $\overline{Qi\text{-}l}$ of the F/F 5 of (i-l)th bit, and a result of the exclusively ORed operation is given to the F/F 5 of (i)the bit. Namely, the test outputs are compressed in parallel to form a signature of the test. Here, the circuit of Fig. 3(A) forms a linear feedback shift register (LFSR) of parallel inputs as shown in Fig. 3(D) to compress the test outputs in parallel and generates a signature.

In compressing the test outputs, the EXOR gates 9 act as gates for carrying out the signature compression. The EXOR gates 9 may be exclusive negative OR gates. The test outputs given to the input terminals Zi and to the gates 9 may be inverted and then given to the gates 9, or the outputs of the F/Fs 5 that tare inverted and given to the gates 9 may be given to the gates 9 without inverting them.

When the control signals A and B are both "1," all the input terminals Zn are 0, and all outputs of the NOR gates 7 are also 0. Therefore, inputs to the respective F/Fs 5 are each 1 to reset the F/Fs 5.

As described in the above, the signature compression circuit of Fig. 3 utilizes combination of the control signals A and B to carry out the signature compression.

The invention does not employ the AND gates 11 of the conventional circuit of Fig. 1 in compressing the test outputs and scanning the signature, thereby reducing the number of elements and size of the parallel signature compression circuit. Since the test outputs are latched without passing through the AND gates 11, an operation speed in normal mode is improved compared with prior arts.

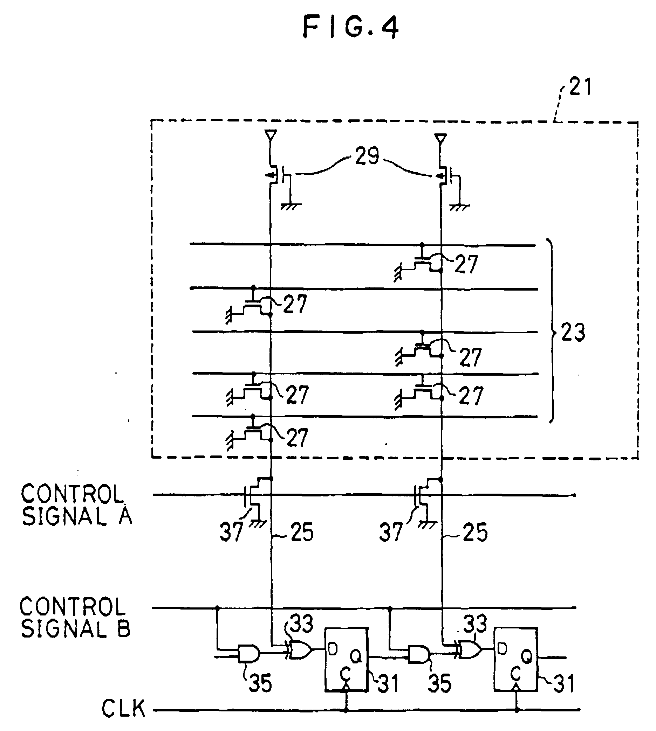

Figure 4 is a view showing a logic circuit 21 to be tested according to the present invention. This logic circuit 21 is a programmable logic array (PLA) and provides ratio-type outputs. Figure 4 shows only two bits of outputs of the circuit 21. In the PLA 21, an AND plane composed of input lines and product term lines is omitted, and only an OR plane is shown.

The OR plane comprises product term lines 23 that are output lines of the AND plate, and output lines 25 orthogonal to the product term lines 23. At predetermined intersections of the product term lines 23 and output lines 25, N-channel MOS transistors (hereinafter referred to as NMOS transistors) 27 are arranged. The NMOS transistors 27 are connected to the output lines 25 and grounded. A gate terminal of each of the NMOS transistors 27 is connected to corresponding one of the product term lines 23. One end of each output line 25 is connected to a power source via a P-channel MOS transistor (hereinafter referred to as PMOS transistor) 29. A gate terminal of the PMOS transistor 29 is grounded.

Logic values of the output lines 25 are determined by logic values of the product term lines 23. Namely, one output line 25 outputs a logic value of 1, if the output lie 25 is connected to one NMOS transistor 27 that is in an ON state because whose gate terminal is connected to one product term line 23 whose logic value is 2. The logic value "0" will be low level potential determined by the ratio of ON resistance of one PMOS transistor 29 and one NMOS transistor 27 of ON state.

On the other hand, the output line 25 outputs a logic value of 1, if all the product term lines 23 corresponding to the NMOS transistors 27 that are connected to the output line 25 in question are 0 to turn OFF the NMOS transistors 27 connected. The outputs of the PLA 21 are given as test outputs to a signature compression circuit.

In Fig. 4, the signature compression circuit comprises D-type flip-flops (F/Fs) 31 forming an output register, EXOR gates 33, AND gates 35 and NMOS transistors 37 that characterize the invention. Each one of the F/Fs 31, EXOR gates 33, AND gates 35 and NMOS transistors 37 constitute a group to be arranged for each output line 25. In the signature compression circuit of Fig. 4, a feedback loop for forming a parallel input LFSR at the time of signature compression is omitted.

In Fig. 4, each F/F 31 corresponds to one bit of the output register. Each F/F 31 fetches data given to its input terminal D in response to a clock signal (CLK), and outputs the fetched data from its output terminal Q.

One input terminal of each EXOR gate 33 is connected to corresponding one of the output lines 25, and the other input terminal of the EXOR gate 33 is connected to an output terminal of corresponding one of the AND gates 35. An output terminal of the EXOR gate 33 is connected to the input terminal D of corresponding F/F 31. Similar to the EXOR gate 9 of Fig. 3, the EXOR gate 33 of Fig. 4 functions to compress signatures.

One input terminal of each AND gate 35 receives a control signal B, and the other input terminal of the same is connected to an output terminal Q of the adjacent F/F 31 on the lower bit side. The other input terminal of the AND gate 35 for the lowest bit is connected to an output terminal of a 2-input selector (Fig. 3). The 2-input selector is controlled by a control signal A. One input of the 2-input selector receives a scan output from other circuit block to be tested. The other input of the selector receives the feedback output of the LFSR. One AND gate 35 functions to receive an output of the adjacent F/F 31 on the lower bit side and transfer the same to the next F/F 31 on the upper bit side. This transfer operation is controlled by the control signal B.

Namely, if the control signal B is at a level of "0," outputs of the AND gates 35 will be each 0 so that logic values of the output lines 25 are given to the input terminals D of the F/Fs 31 via the EXOR gates 33. Namely, test outputs of the PLA 21 given to the output lines 25 are latched by the F/Fs 31 to perform normal operation.

When the control signal B is at a level of "1," an output of one AND gate 35 is an output of the adjacent F/F 31 on the lower bit side. Therefore, a logic value of one output line 25 is exclusively ORed in the corresponding EXOR gate 33 with an output of the adjacent F/F 31 on the lower bit side. As a result, if the control signal A is at a level of "0," outputs of the PLA 21 given to the output lines 25 are compressed in parallel. The outputs of the PLA 21 are controlled according to the NMOS transistors 37 and control signal A and given to the output lines 25.

Each of the NMOS transistors 37 is connected to corresponding one of the output lines 25 and grounded. Gate terminals of the NMOS transistors 37 commonly receive the control signal A so that the NMOS transistors 37 may be turned ON and OFF according to the control signal A. The gate length of the NMOS transistor 37 is substantially equal to or larger than that of the NMOS transistor 27 disposed at an intersection of the corresponding product term line 23 and output line 25. Accordingly, ON resistance of the NMOS transistor 37 is substantially equal to or smaller than that of the NMOS transistor 27.

The NMOS transistors 37 will be turned OFF when the control signal A is at a level of "0." Then, test outputs of the PLA 231 are given to the output lines 25. If the control signal B is at level 0, the test outputs are latched as they are by the F/Fs 31. If the control signal B is at level 1, the test outputs are compressed in parallel and fetched by the F/Fs 31.

When the test outputs are fetched by the F/Fs 31, junction capacitance of each NMOS transistor 37 is added to each output line 25. However, usually the junction capacitance is negligibly small compared to total capacitance connected to each output line 25. Therefore, a speed of providing outputs from the PLA 21 is substantially equal to that with no NMOS transistors 37 connected to the output lines 25.

When the control signal A is at level 1, all the NMOS transistors 37 are turned ON. Therefore, all the output lines 25 provides logic values each of 0. Then, an output of one F/F 31 is transferred to the next F/F 31 on the upper bit side via the corresponding AND agate 35 and EXOR gate 33, thus carrying out scan operation.

As explained with reference to Fig. 3, the AND gates 35 and EXOR gates 33 mlay be replaced with other logic gates having smaller areas, if such gates can achieve the parallel signature compression.

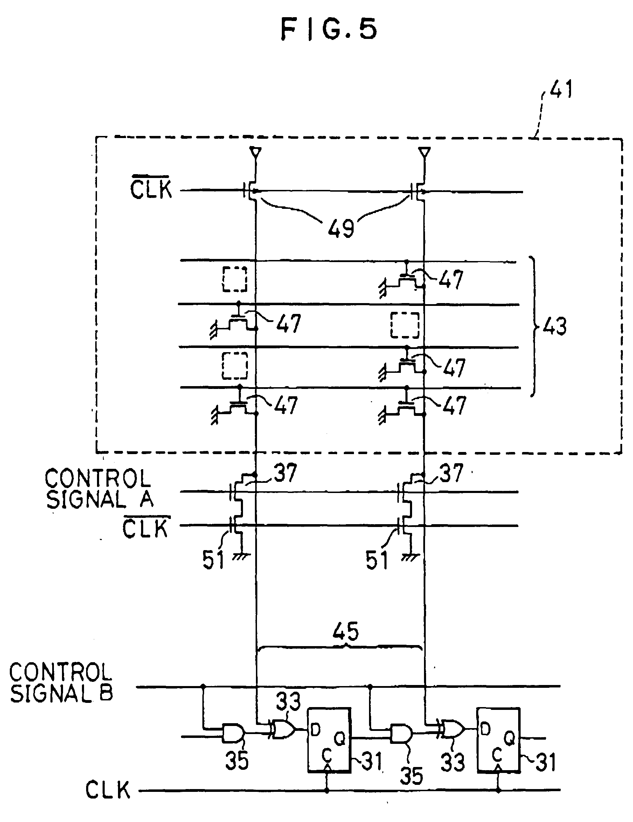

Figure 5 shows a signature compression circuit applicable for a logic circuit providing dynamic type outputs, according to another embodiment of the invention.

This embodiment tests a precharge type NOR-ROM 41. In Fig. 5, the same parts as those shown in Fig. 4 are represented with like reference marks and their explanations will be omitted. In Fig. 5, a feedback loop for achieving a parallel input LFSR is omitted.

In Fig. 5, the ROM 41 has word lines 43 and bit lines 45 that form output lines and are orthogonal to the word lines 43. At predetermined intersections, NMOS transistors 47 are connected to the bit lines 45 and grounded. A gate terminal of each NMOS transistor 47 is connected to corresponding one of the word lines 43.

Each bit line 45 is connected to a power source via a precharging PMOS transistor 49. A gate terminal of each PMOS transistor 49 receives an inverted clock signal (CLK) derived by inverting a clock signal (CLK). While the clock signal is being at a level of 1, the bit lines 45 are precharged. At this time, to secure the precharging, all the word lines 43 are set to level 0 so that all the NMOS transistors 47 are turned OFF. On the other hand, while the clock signal is being at level 0, the bit lines 45 receive output corresponding to potentials of the word lines 43 that turn ON and OFF the NMOS transistors 47 connected to the bit lines 45.

The signature compression circuit of the embodiment for testing such a ROM 41 is provided with, in addition to the arrangement shown in Fig. 4, NMOS transistors 51 for securing precharge.

Each NMOS transistor 51 is connected to corresponding one of the NMOS transistors 37 and grounded. A gate terminal of the NMOS transistor 51 receives an inverted clock signal. Namely, each bit line 45 is grounded via the corresponding NMOS transistor 37 and NMOS transistor 51 that are connected in series. If a clock signal is at level 1 during a precharging period of the bit lines 45, the NMOS transistors 51 are turned OFF. Therefore, the bit lines 45 are precharged securely.

With this arrangement, when the clock signal is at level 0 during a period of outputting data of the ROM 41, the NMOS transistors 51 are turned ON. Therefore, similar to the previous embodiment, the normal operation, parallel signature compression operation and scanning operation are carried out based on the control signals A and B.

If it is arranged such that a signal derived by operating AND of the control signal A and inverted clock signal ($\overline{\text{CLK}}$) is given to gate terminals of the NMOS transistors 37, the NMOS transistors 51 may be omitted.

Therefore, this invention can provide the same effect as that provided by the embodiment of Fig. 4. The signature compression circuits shown in Figs. 4 and 5 can easily be assembled in ROMs, RAMs, PLAs, etc., that are appropriate to be tested according to the parallel signature compression method.

As described in the above, the present invention turns ON (or OFF) transistors to put test outputs in a predetermined logic level to carry out scan operation. With this arrangement, the invention can reduce the size of structure and improve an operation speed.

**Claims**

1.  A signature compression circuit connected to parallel output lines ($Z_1..Z_n$) of a logic circuit for testing the operation of the circuit by means of a built-in logic observer comprising a linear feedback shift register, said built-in logic observer having parallel input and output terminals and a serial output terminal and receiving signals from the output lines ($Z_1..Z_n$) of the circuit under test through the input terminal in parallel, said built-in logic observer operating in first, second and third modes in accordance with first and second control signals (A, B), said built-in logic signal transferring signals from the parallel input terminals to the parallel output terminals without change in the first mode, said built-in logic circuit carrying out signature compression of signals appearing at the output lines in the second mode and said built-in logic circuit outputting a result of the signature from the serial output terminal by shifting operation in the third mode;

characterized in that the output lines ($Z_1..Z_n$) provide ratio-type or dynamic type outputs and that the parallel input terminals are coupled to a common logic level through transistors (15) which are controlled by one of the first and second control signals (A, B) in order to selectively set all the outputs lines at the common level.

2. The signature compression circuit of claim 1 characterized in that each of said transistors (15) comprises a MOSFET.

3. The signature compression circuit of claim 2 characterized in that said logic circuit is a ROM.

4. The signiture compression circuit of claim 3 characterized in that said logic circuit is a PLA.

5. The signature compression circuit of claim 2 characterized in that said linear feedback shift register comprises a plurality of flip-flops (5), each flip-flop (5) being provided with a NOR gate (7) and an exclusive OR gate (9).

**Patentansprüche**

1. Signatur-Kompressionsschaltung, die mit parallelen Ausgangsleitungen ($Z_1 .. Z_n$) einer Logikschaltung verbunden ist, zum Testen des Betriebs der Schaltung mittels eines eingebauten Logikbetrachters, der ein Schieberegister mit linearer Rückkopplung umfaßt, wobei der eingebaute Logikbetrachter parallele Eingangs- und Ausgangsanschlüsse und einen seriellen Ausgangsanschluß aufweist und Signale von den Ausgangsleitungen ($Z_1 .. Z_n$) der sich unter einen Test befindlichen Schaltung durch den Eingangsanschluß parallel empfängt, wobei der eingebaute Logikbetrachter in ersten, zweiten und dritten Moden gemäß erster und zweiter Steuersignale (A, B) arbeitet, wobei das eingebaute Logiksignal von den parallelen Eingangsanschlüssen an die parallelen Ausgangsanschlüsse ohne eine Änderung in dem ersten Modus überträgt, die eingebaute Logikschaltung eine sk Signatur-Kompression von Signalen, die an den Ausgangsleitungen auftreten, in dem zweiten Modus ausführt und die eingebaute Logikschaltung ein Ergebnis der Signatur von dem seriellen Ausgangsanschluß durch einen Verschiebebetrieb in dem dritten Modus ausgibt;

***dadurch gekennzeichnet, daß***

die Ausgangsleitungen ($Z_1 .. Z_n$) Ausgänge vom Verhältnis-Typ oder eines dynamischen Typs bereitstellen und daß die parallelen Eingangsanschlüsse mit einem gemeinsamen Logikpegel über Transistoren (15) gekoppelt sind, die von einem der ersten und zweiten Steuersignale (A, B) gesteuert werden, um selektiv alle Ausgangsleitungen auf den gemeinsamen Pegel zu legen.

2. Signatur-Kompressionsschaltung nach Anspruch 1, dadurch gekennzeichnet, daß jeder der Transistoren (15) einen MOSFET umfaßt.

3. Signatur-Kompressionsschaltung nach Anspruch 2, dadurch gekennzeichnet, daß die Logikschaltung ein ROM ist.

4. Signatur-Kompressionsschaltung nach Anspruch 3, dadurch gekennzeichnet, daß die Logikschaltung ein PLA ist.

5. Signatur-Kompressionsschaltung nach Anspruch 2, dadurch gekennzeichnet, daß das Schieberegister mit linearer Rückkopplung eine Vielzahl von Flip-Flops (5) umfaßt, wobei jedes Flip-Flop (5) mit einem NOR-Gatter (7) und einem Exclusiv-ODER-Gatter (9) versehen ist.

**Revendications**

1. Circuit de compression de signature connecté à des lignes de sortie parallèles ($Z_1...Z_n$) d'un circuit logique pour tester le fonctionnement du circuit au moyen d'un observateur logique incorporé comprenant un registre à décalage linéaire à rétroaction, ledit observateur logique incorporé comportant des bornes d'entrée et de sortie parallèles et une borne de sortie série et recevant des signaux des lignes de sortie ($Z_1...Z_n$) du circuit en cours de test par l'intermédiaire de la borne d'entrée en parallèle, ledit observateur logique incorporé fonctionnant dans des premier, deuxième et troisième modes en accord avec les premier et deuxième signaux (A, B), ledit circuit logique incorporé transférant les signaux des bornes d'entrée parallèles aux bornes de sortie parallèles sans changement dans le premier mode, ledit circuit logique incorporé effectuant une compression de signature des signaux apparaissant sur les lignes de sortie dans le deuxième mode et ledit circuit logique incorporé délivrant un résultat de la signature à partir de la borne de sortie série par une opération de décalage dans le troisième mode;

caractérisé en ce que les lignes de sortie ($Z_1$... $Z_n$) fournissent des sorties du type rapport ou du type dynamique et que les bornes d'entrée parallèles sont couplées à un niveau logique commun par l'intermédiaire de transistors (15) qui sont commandés par un des premier et deuxième signaux de commande (A, B) afin d'amener sélectivement toutes les lignes de sortie au niveau commun.

2. Circuit de compression de signature selon la revendication 1, caractérisé en ce que chacun desdits transistors (15) comprend un transistor à effet de champ à métal-oxyde-semiconducteur (MOSFET).

3. Circuit de compression de signature selon la revendication 2, caractérisé en ce que ledit circuit logique est une mémoire morte (ROM).

4. Circuit de compression de signature selon la revendication 3, caractérisé en ce que ledit circuit logique est une matrice logique programmable (PLA).

5. Circuit de compression de signature selon la revendication 2, caractérisé en ce que le registre à décalage linéaire à rétroaction comprend une pluralité de bistables (5) chaque bistable (5) étant pourvu d'une porte NON-OU (NOR) (7) et d'une porte OU exclusif (NOR) (9).

# F I G. 1

TEST INPUT PATTERN

COMBINATION CIRCUIT ~1

TEST OUTPUTS

3 OUTPUT REGISTER

# FIG.2

EP 0 350 888 B1

FIG.3(A)

CONTROL SIGNAL A
CONTROL SIGNAL B
$S_{in}$
MUX
15

$Z_1$ $Z_2$ $Z_3$ $Z_4$ $Z_5$ $Z_6$ $Z_7$ $Z_8$

$Q_1$ $Q_2$ $Q_3$ $Q_4$ $Q_5$ $Q_6$ $Q_7$ $Q_8$

$S_{out}$

FIG.3(B)

$Z_1$ $Z_2$ $Z_3$ $Z_4$ $Z_5$ $Z_6$ $Z_7$ $Z_8$

$Q_1$ $Q_2$ $Q_3$ $Q_4$ $Q_5$ $Q_6$ $Q_7$ $Q_8$

# F I G. 3(C)

# F I G. 3(D)

EP 0 350 888 B1

# F I G. 4

CONTROL SIGNAL A

CONTROL SIGNAL B

CLK

# FIG.5